Europäisches Patentamt

European Patent Office

Office européen des brevets

(19)

(11) Publication number : **0 466 394 A2**

## (12) EUROPEAN PATENT APPLICATION

(21) Application number : **91306055.4**

(22) Date of filing : **03.07.91**

(51) Int. Cl.⁵ : **G06F 15/16**

(30) Priority : **09.07.90 JP 180995/90**

(43) Date of publication of application :
**15.01.92 Bulletin 92/03**

(84) Designated Contracting States :
**AT BE CH DE DK ES FR GB GR IT LI LU NL SE**

(71) Applicant : **GRAPHICO CO. LTD.**
**11-14, Higashikanda 1-chome**
**Chiyoda-ku, Tokyo 101 (JP)**

(72) Inventor : **Takashima, Tokuhei**
**20-15 Kamisoshigaya 3-chome**
**Setagaya-ku, Tokyo, 158 (JP)**

(74) Representative : **Skone James, Robert**
**Edmund et al**
**GILL JENNINGS & EVERY 53-64 Chancery**
**Lane**
**London WC2A 1HN (GB)**

(54) Connector assembly.

(57)   Disclosed is a connector assembly for a parallel-processing device, the assembly comprising a pile of bus disks (7) each having an integrated circuit crossbar switch (9) at its centre and a plurality of conductor lines (13) radiating from the centre crossbar switch, thus providing communication lines of equal length to make a required electrical connection between selected processing units. This eliminates the necessity of adjusting different transmission times in communication between selected processing units, and accordingly the time involved for processing is shortened. A pile of numerous disks permit interconnection of numerous processing units therearound through the shortest possible conductor lines, thus making the processing units insensitive to interference by noise signals.

EP 0 466 394 A2

FIG. 1

The present invention relates to a connector assembly for a parallel-processing device which permits a plurality of processing units such as processors or memories to perform their processings simultaneously, substantially reducing the time involved for different processings. Such parallel-processing devices are appropriate, for instance, for processing color image data at high speed.

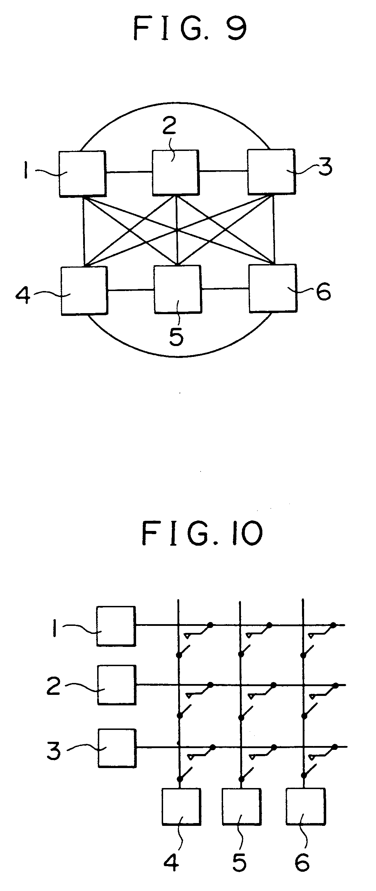

There are two kinds of parallel-processing devices. One kind of parallel processing device is a complete connection type in which a plurality of processing elements 1 through 6 such as processors or memories are connected together by a plurality of buses, as shown in Fig. 9. The other kind of processing device uses a crossbar switch to interconnect a plurality of processing elements 1 through 6, as shown in Fig. 10.

In the complete connection type of parallel-processing device, transmission distances between selected processing units are different, and accordingly transmission time varies with processing units. Therefore, it is necessary that the parallel processing device is equipped with means to reduce transmission time differences to a minimum. This control, however, is difficult and complicated, and is the cause for preventing data transmission at high speed.

As for the parallel processing device using a crossbar switch, the number of crossing contacts in the crossbar switch will increase with the number of the processing elements to be connected, and accordingly the device will become bulky. Because of relatively long transmission distance, a disadvantage still exists, however in that the device will likely be subjected to interference by exterior noise signals, and that the device will produce noise signals.

In accordance with the present invention, a connector assembly for connecting a plurality of processing elements in a parallel-processing device comprises a plurality of bus disks arranged along a common axis, each disk having an integrated circuit crossbar switch at its centre and a plurality of signal conductor lines of substantially equal length radially extending thereon from the crossbar switch to the circumference of respective bus disks for connection to processing elements wherein the switch is controllable to open and close an interior contact at each crossing of the signal conductor lines in the crossbar switch according to a predetermined sequence.

The present invention enables a parallel-processing device to be provided which permits data-processing at an increased speed and which is insensitive to noise signals. The present invention also enables a parallel-processing device to be provided whose size can be substantially reduced.

The signal conductor lines radiating from the center crossbar switch on each disk constitute parallel buses, and can be allotted to data lines, address lines, control lines and the like.

In operation, a control means performs the opening-and-closing operation of all contacts in the crossbar switch according to a predetermined sequence. Thus, a plurality of processing units such as processors, memories and the like can be selectively electrically connected at one time through the agency of the crossbar switch and associated conductor lines, thereby permitting simultaneous transmission of data between selected processing units and simultaneous processing of data by such selected processing units.

The crossbar switch is an integrated circuit, and therefore, it is very small, and the signal conductor lines radiating from the center crossbar switch are of equal length. Consequently, all processing units can be interconnected by conductor lines of equal length. Therefore, the transmission distance between selected processing units are substantially equalized. This makes it possible to perform accurate, high-speed transmission control, and hence high-speed data processing.

Accumulation of bus disks in the form of a pile permits interconnection of numerous processing units via conductor lines of relatively short length radiating from the center crossbar switch, thus rendering them less sensitive to noise signals because of a shortened transmission distance between selected processing units. The use of the pile of bus disks permits reduction of the device size.

Other objects and advantages of the present invention will be understood from the following description of parallel-processing devices according to preferred embodiments of the present invention, which are shown in the accompanying drawings:

Fig. 1 is a plan view of a bus disk which is equipped with a crossbar switch and is used in a parallel-processing device according to the present invention;

Fig. 2 is a diagram of an equivalent circuit of a crossbar switch;

Fig. 3 is a perspective view of a vertical arrangement of bus disks;

Fig. 4 is a perspective view of a parallel-processing device according to the present invention;

Fig. 5 is a flowchart describing how data can be parallel-processed;

Fig. 6 is a plan view of a bus disk which is equipped with a crossbar switch at its center and is used in a parallel-processing device according to the present invention;

Fig. 7 is a side view of a parallel-processing device according to the present invention;

Fig. 8 is a plan view of the device of Fig. 7;

Fig. 9 is a diagram of a conventional parallel-processing device; and

Fig. 10 is a diagram of another conventional parallel-processing device.

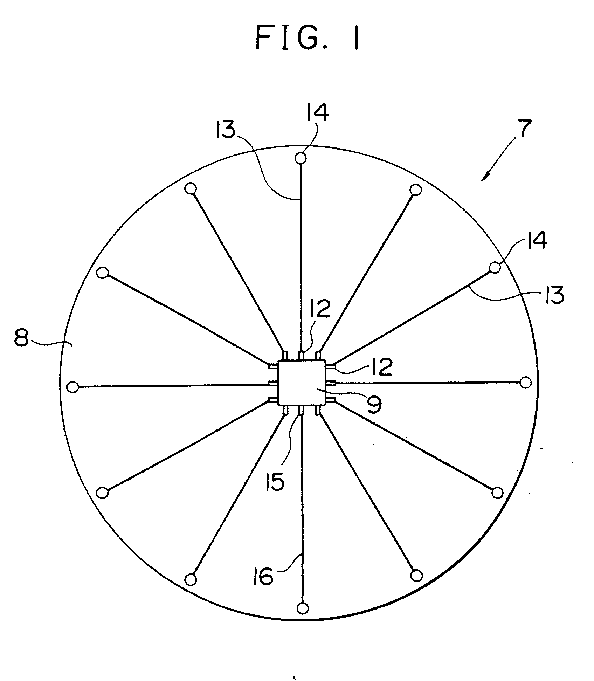

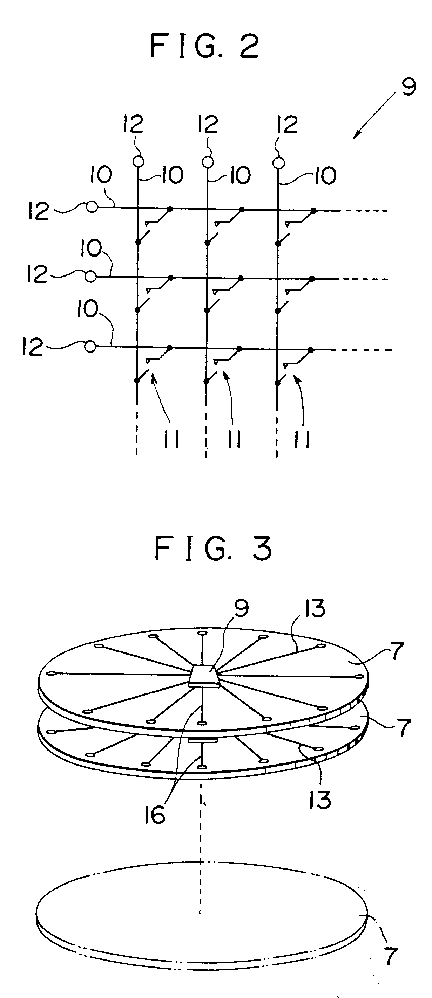

Referring to Fig. 1, there is shown one example of a bus disk 7 which has a plurality of conductor lines 13 printed on its circular board 8 and radiating from a center crossbar switch 9. The crossbar switch 9 is built in the form of an integrated circuit. As seen from Fig. 2, the crossbar switch has one contact 11 at each crossing of vertical and horizontal signal conductor lines 10. Each signal conductor line 10 in the crossbar switch 9 is terminated at terminal 12 for exterior connection.

As seen from Fig. 1, a plurality of conductor lines 13 of equal length are connected to the terminals 12 of the crossbar switch 9. These conductor lines 13 radiate from the crossbar switch 9 on the printed board 8, ending with terminals 14 for exterior connection.

The crossbar switch 9 has a plurality of control terminals 15 for controlling the opening-and-closing of contacts at crossings (although shown as a single tip in the drawing for the sake of simplicity), and the plurality of control conductor lines 16 are printed on the board and are connected to the control terminals 15 (although shown as a single line in the drawingfor the sake of simplicity).

As shown in Fig. 3, a plurality of bus disks 7 each bearing a crossbar switch and a plurality of conductor lines radiating therefrom, are vertically arranged along one common axis at regular intervals. The communication conductor lines 13 and crossbar switch control conductor lines 16 are arranged at regular angular intervals. The communication conductor lines 13 are to be used as parallel buses, and to be allotted and used as data lines, address lines, control lines and the like.

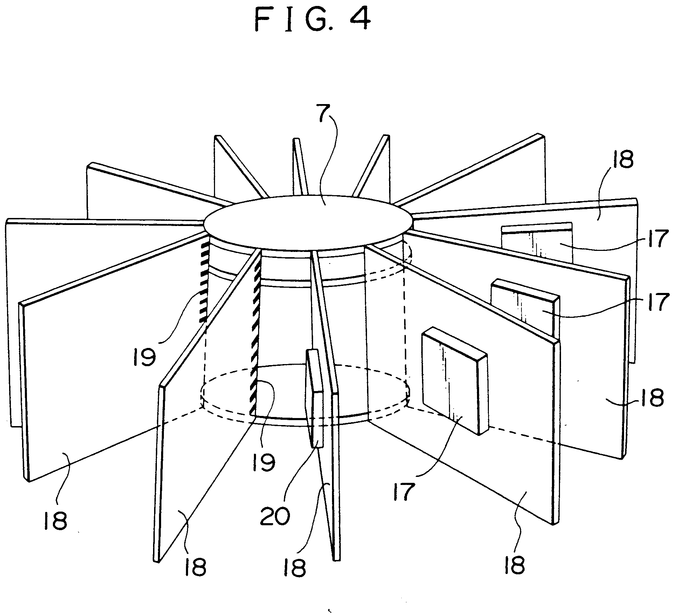

As seen from Fig. 4, a plurality of upright printed boards 18 each bearing a processing unit 17 are arranged radially around a pile of bus disks. Each upright printed board 18 has a plwality of terminals 19 for exterior connection on its inner vertical edge. These terminals are electrically connected to corresponding terminals 14 on the circumference of each bus disk 7 via connectors (not shown).

A selected printed board 18 is equipped with a crossbar switch controller 20, which is connected to the crossbar switch control line 16 of each bus disk, thereby controlling the opening-and-closing of each crossing contact 11 in the crossbar switch 9.

The processing units 17 which are fixed on the printed boards 18 may be central processing units, memories, and input/output processors for controlling the input/output devices of keyboards or display devices.

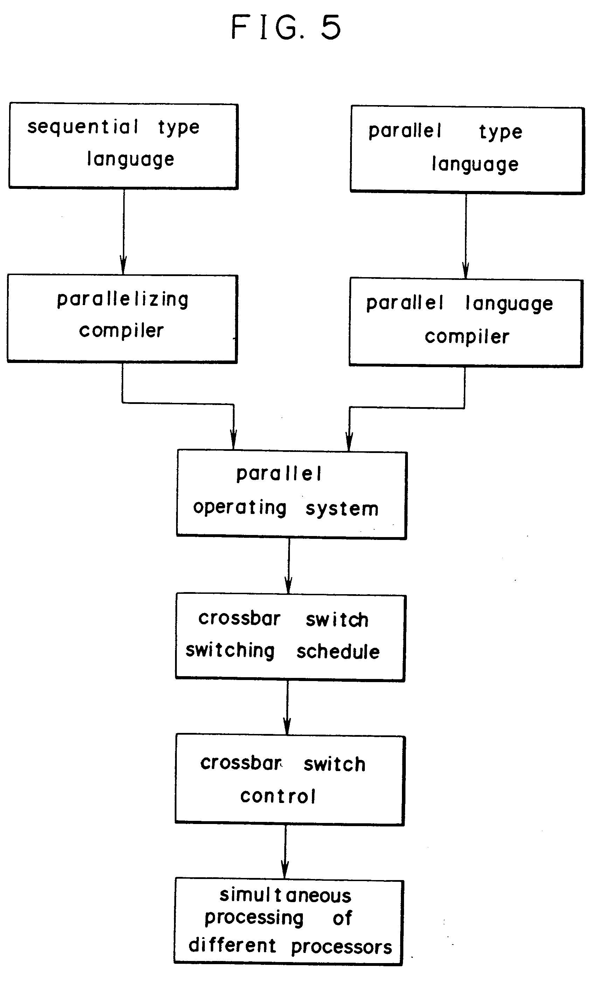

Referring to Fig. 5, the manner in which parallel processing is carried out in a parallel-processing device according to the present invention, is described below. Assume that a program according to which a given task such as color imaging processing is performed, is prepared in sequential type language such as FORTRAN or in parallel type language, and stored in memories.

For the program expressed in the sequential type language, a parallelizing compiler will find out which parts of the program can be parallel-performed, and then it will rearrange such parts in parallel tasks. With the program expressed in the parallel type language, a parallel language compiler will selectively pick up parallel parts so that parallel machine codes may be prepared.

The operating system of the parallel machine will carry out dynamic allotment of processors, and the switching controlling schedule of each crossbar switch will be prepared on the basis of the allotment of processors. In this way parallel-processing will be handled.

The crossbar switch controller 20 performs the switching of all crossing contacts 11 in each crossbar switch 9 according to the schedule, thereby permitting all processing units 17 to process data simultaneously.

Disks are described as having a crossbar switch and radiating conductor lines on one side. As a matter of course, disks may have a crossbar switch and conductor lines on opposite sides. Otherwise, they may be a multi-layered or lamination disk having a crossbar switch and conductor lines printed on each layer.

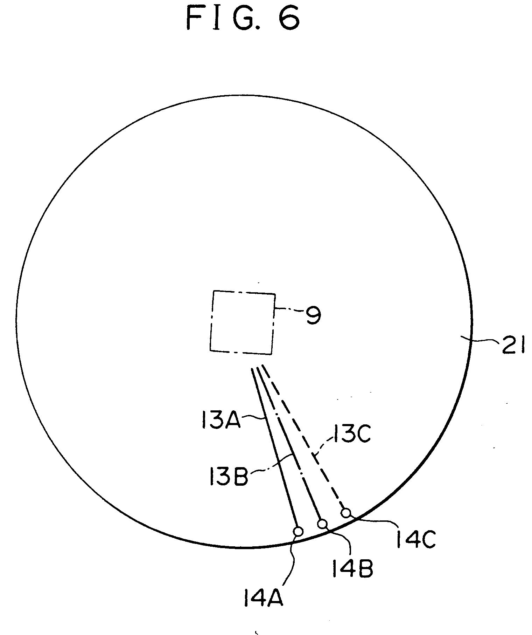

Referring to Fig. 6, one example of a three-layered bus disk is described below.

The bus disk 21 is composed of upper, intermediate and lower layers each having communication conductor lines 13A, 13B or 13C. The communication conductor lines of the upper, intermediate and lower layers are arranged offset relative to each of the other layers. These conductor lines 13A, 13B and 13C are terminated by terminals 14A, 14B and 14C, respectively.

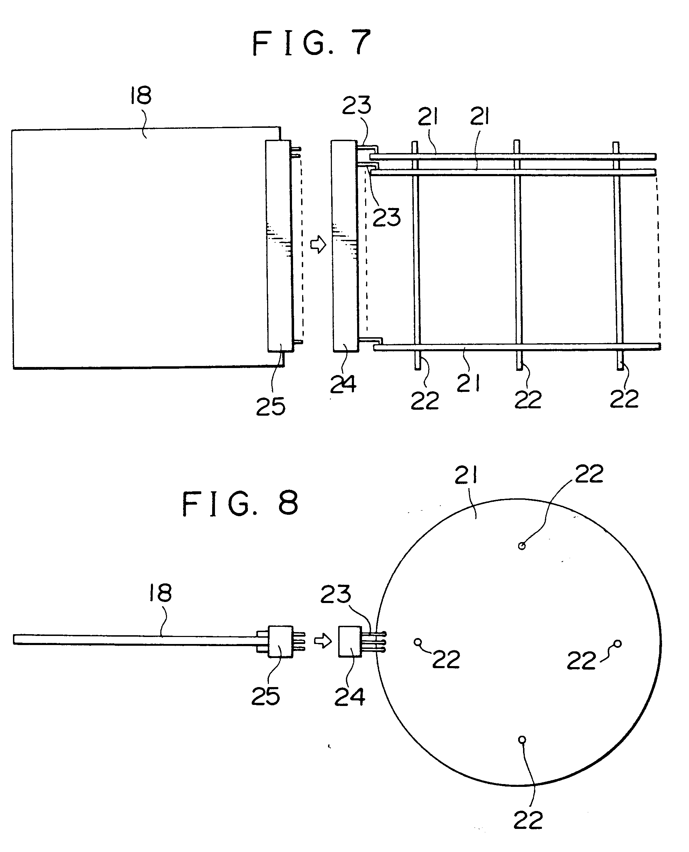

As shown in Fig. 7, such lamination bus disks 21 are arranged vertically and are integrated by four upright rods 22 in the same fashion as in Fig. 4. The terminals 14A, 14B and 14C of each bus disk 21 are connected to a female receptacle 24, which has pins 23 arranged in three lines. Each printed board 18 has a male plug 25 on its inner vertical edge. All printed boards can be connected to the pile of disks 21 by mating the male plugs 25 of the printed boards 18 with the female receptacles 24 of the bus disks 21 (See Figs. 7 and 8).

The use of lamination disks makes it possible to substantially increase the density and compactness of elements in a parallel-processing device, and accordingly reduce the size of the device.

In the case where a parallel-processing device according to the present invention is used in processing color-image data and outputting the processed data to a display device, red, green and blue data retrieved from different memories are further processed, and then the processed data are further transferred to selected I/O CPUs by controlling the crossbar switch of the parallel-processing device, thus omitting transmission of data between memories.

In the case where a parallel-processing device according to the present invention is used in color printing, selected CPUs of the parallel processing device are allotted to yellow, cyan, magenta, and black to perform required processings simultaneously. When processing large amounts of data it is possible to store divisions of data in different sections of a selected memory, thereby permitting distribution of the CPUs'processing domain. In this case data transmission can be omitted, and accordingly quick processing results are achieved.

In the case where a parallel-processing device according to the present invention is used in the production of motion pictures such as animated cartoons, one CPU can be allotted to each frame to perform necessary processing, thereby permitting real time processing.

As may be understood from the above, a parallel-processing device according to the present: invention uses a pile of bus disks each having an integrated circuit crossbar switch at its center and a plurality 'of conductor lines radiating from the center crossbar switch, thus providing communication lines of equal length to make a required electrical connection between selected processing units. This eliminates the necessity of adjusting different transmission times in communication between selected processing units, and accordingly the time involved for processing is shortened.

A pile of numerous disks permit interconnection of numerous processing units therearound through the shortest possible conductor lines, thus making the processing units insensitive to interference by noise signals.

## Claims

1. A connector assembly for connecting a plurality of processing elements in a parallel-processing device the assembly comprising a plurality of bus disks (7) arranged along a common axis, each disk having an integrated circuit crossbar switch (9) at its centre and a plurality of signal conductor lines (13) of substantially equal length radially extending thereon from the crossbar switch to the circumference of respective bus disks for connection to processing elements wherein the switch (9) is controllable to open and close an interior contact at each crossing of the signal conductor lines in the crossbar switch according to a predetermined sequence.

2. An assembly according to claim 1, wherein each of the plurality of bus disks (7) is a three-layered bus disk composed of upper, intermediate and lower layers each having a respective signal conductor line (13A-13C).

3. An assembly according to claim 2, wherein the signal conductor lines (13A-13C) are angularly offset relative to each other and include terminals at distal ends thereof, respectively, whereby the terminals of each of the plurality of three-layered bus disks are connected in use to a plurality of processing elements arranged around the plurality of three-layered bus disks.

4. A parallel-processing device comprising a connector assembly according to any of the preceding claims; and a plurality of processing elements (18) arranged around the bus disks, an exterior contact of each of the plurality of processing elements being electrically connected at a terminal end of each radial signal conductor line.

5. A parallel-processing device according to claim 4, wherein the plurality of processing elements (18) includes an upright printed circuit board, a processing unit, and a plurality of terminals formed on an inner vertical edge of the printed circuit board for exterior connection to corresponding ones of the terminal ends of each radial signal conductor line (13).

6. A parallel-processing device according to claim 4 or claim 5, further comprising means for controlling an opening-and-closing operation of the crossbar switches constituted by a crossbar switch controller connected to the signal conductor lines (13) of each of the plurality of bus disks (7).

7. A parallel-processing device according to any of claims 4 to 6, wherein the terminals of each of the plurality of bus disks (7) are connected to the plurality of processing elements by a male/female connector (24,25).

# FIG. 1

# F I G. 2

# F I G. 3

# F I G. 4

# FIG. 5

```
┌─────────────────┐          ┌─────────────────┐
│ sequential type │          │ parallel   type │
│    language     │          │    language     │
└────────┬────────┘          └────────┬────────┘
         │                            │
         ▼                            ▼
┌─────────────────┐          ┌─────────────────┐
│  parallelizing  │          │parallel language│
│    compiler     │          │    compiler     │
└────────┬────────┘          └────────┬────────┘
         │                            │
         └──────────┐      ┌──────────┘
                    ▼      ▼
          ┌─────────────────────┐
          │      parallel       │
          │  operating  system  │
          └──────────┬──────────┘
                     │
                     ▼
          ┌─────────────────────┐
          │  crossbar   switch  │
          │ switching  schedule │
          └──────────┬──────────┘
                     │
                     ▼
          ┌─────────────────────┐
          │  crossbar   switch  │
          │      control        │
          └──────────┬──────────┘
                     │
                     ▼
          ┌─────────────────────┐
          │    simultaneous     │
          │  processing   of    │
          │ different processors│
          └─────────────────────┘
```

9

# FIG. 6

# F I G. 7

# F I G. 8

11

# FIG. 9

# FIG. 10